# EUROPEAN PATENT APPLICATION

(11) **EP 3 968 363 A1**
(43) Date of publication of application: **16.03.2022**
(21) Application number: 20802392.9
(22) Date of filing: 07.05.2020
(51) Int. Cl.: H01L 21/66

(54) **METHOD AND SYSTEM FOR AUTOMATED DETECTION AND CONTROL OF DEFECTS ON WAFER**

(30) Priority: 07.05.2019 CN 201910376534; 03.04.2020 CN 202010257939
(71) Applicant: Xuzhou Xinjing Semiconductor Technology Co., Ltd., Xuzhou, Jiangsu 221004 (CN)
(72) Inventor: ZHENG, Jiazhen, Xuzhou, Jiangsu 221004 (CN); CHEN, Chien-Ming, Xuzhou, Jiangsu 221004 (CN); LOW, Kin Peng, Xuzhou, Jiangsu 221004 (CN)
(74) Representative: Penza, Giancarlo
(86) International application number: PCT/CN2020/088889
(87) International publication number: WO 2020/224612

(57) **Abstract**

The present disclosure provides a method and a system for automatically detecting and controlling defects on a wafer. The method includes the following steps: providing at least one stacked wafer; constructing a defect distribution map based on a defect information on each of the at least one wafer, wherein, the defect information includes the number of defects, types of the defects, and locations of the defects; partitioning at least one predetermined region (30) in the defect distribution map; determining the number of predetermined defects in each of the at least one predetermined region (30) based on the locations of the defects; comparing the number of the predetermined defects in the each of the at least one predetermined region (30) with a set threshold, and determining detection results based on comparison results.

## Description

### Cross-Reference to Related Applications

The present disclosure claims the priority to application No. 201910376534.7, filed to China National Intellectual Property Administration (CNIPA) on May 7, 2019, and application No. 202010257939.1, filed to CNIPA on April 3, 2020, which are incorporated in the present disclosure by reference in its entirety.

### Technical Field

The present disclosure relates to the field of wafer detection technologies, and more particularly, to a method and a system for automatically detecting and controlling defects on a wafer.

### Background

In a wafer manufacturing process, various defects such as cop (crystal original particle), pits (etch pits), particles, scratches, slips, bright field defects, a pin hole (an air pocket) or the like may occur on a surface of a wafer. At present, a plurality of detection apparatuses are usedto detect defects on the wafer, but only a single defect is determined based on detection results of a single apparatus. This forgoing detection and determination method is not sufficient to ensure quality of the produced wafer, resulting in a high defect rate of a subsequent chip.

In addition, contamination during a processing process or processing itself also cause many defects, such as saw marks formed after wire cutting, grinding marks formed by uneven single/double-sided grinding, bumps or defects (such as: process induced defect) formed after polishing, dislocation slips generated after heat treatment, wear or scratches caused by a robot arm during transportation, or the like. The forgoing defect types may occur at various locations on the wafer, mostly at an edge of the wafer. Since the detection apparatus is a single wafer detection, it is difficult to find the cause of its occurrence from the defect information on a single wafer. Especially those wafers with edge defects still meet customer specifications, and it is more difficult to detect continuously generated problems that may be caused by improper processing.

Therefore, existing wafer detection related technology still needs to be improved.

### Summary

Some embodiments of the present disclosure aims to solve one of the technical problems in existing wafer detection related technology at least to a certain extent. For this reason, an embodiment of the present disclosure provides a method and a system for automatically detecting and controlling defects on a wafer that can better guarantee quality of an output chip.

In one aspect of the present disclosure, the present disclosure provides a method for automatically detecting and controlling defects on a wafer. According to an embodiment of the present disclosure, the method includes: providing at least one stacked wafer; constructing a defect distribution map based on the defect information on each of the at least one wafer, wherethe defect information includes the number of defects, types of the defects, and locations of the defects; partitioning at least one predetermined region in the defect distribution map; determining the number of predetermined defects in each of the at least one predetermined region based on the locations of the defects; comparing the number of the predetermined defects in the each of the at least one predetermined region with a set threshold, and determining a detection result based on a comparison result. The forgoing methodcan not only controll the number and the types of the defects on the wafer, but also controll the distribution of the defects, thereby avoiding problems caused by a concentration of defect distribution, and better ensuring a quality of the produced chips. Selection of the types of the determined defects can effectively reflect problems existing in the wafer processing process which is of great significance for guiding the manufacturing process of the wafer.

According to an embodiment of the present disclosure, a 2D defect distribution map is constructed based on the number of defects and locations of the defects on a first surface of one wafer.

According to an embodiment of the present disclosure, an outer circumference of the first surface forms a first circle; an intersection of a plurality of second circles that are concentric with the first circle and a plurality of diameters passing through a center of the first circle defines a plurality of the predetermined regions.

According to an embodiment of the present disclosure, the each predetermined region is a circular region defined by a predetermined radius with one of the defects as a circle center, and each of the defects corresponds to one of the plurality of the predetermined region.

According to an embodiment of the present disclosure, an area of the each of the predetermined region is 0.5%^{~}5% of a total area of the 2D defect distribution map.

According to an embodiment of the present disclosure, the number of the predetermined defects is a sum of the number of all the defects in a corresponding predetermined region.

According to an embodiment of the present disclosure, based on the comparison result, a step of determining the detection result includes: determining as a qualified region the predetermined region where the number of the predetermined defects is less than the set threshold, and determining as an unqualified region the predetermined region where the number of the predetermined defects is greater than or equal to the set threshold.

According to an embodiment of the present disclosure, a 3D defect distribution map is constructed based on a 3D space occupied by a plurality of wafers, the number of defects and the locations of the defects on the plurality of wafers.

According to an embodiment of the present disclosure, the each predetermined region is the 3D space occupied by the plurality of the wafers.

According to an embodiment of the present disclosure, the each predetermined region is a cylindrical region delineated by a predetermined bottom radius with a straight line passing through one of the defects and parallel to a stacking direction of the plurality of wafers as a central axis. Each of the defects corresponds to one of the predetermined regions.

According to an embodiment of the present disclosure, the number of the predetermined defects is the number of defects with a same location of the defects on different wafers.

According to an embodiment of the present disclosure, based on the comparison result, the step of determining the detection results includes any one of the following steps: determining as a qualified region the predetermined region where the number of the predetermined defects is less than the set threshold, and determining as an unqualified region the predetermined region where the number of the predetermined defects is greater than or equal to the set threshold; if a plurality of stacked wafers are derived from the same ingot, and the number of predetermined defects is greater than or equal to the set threshold, determining the predetermined defects originates from a preparation and processing process of the wafer.

According to an embodiment of the present disclosure, a volume of each of the predetermined regions is 0.5%^{~}5% of a total volume of the 3D space occupied by the plurality of wafers.

According to an embodiment of the present disclosure, each predetermined region is the 3D space occupied by a plurality of the wafers, and the method includes: acquiring images of the plurality of wafers thatare from the same ingot, and positioning points are formed on edges of the plurality of wafers, respectively; stereoscopically overlapping and processing the images of the plurality of wafers based on the positioning points, thereby acquiring an overlapped image of the plurality of wafers; searching for defects on the overlapped image to determine whether there are continuous defects, wherein, the continuous defects occur at a same location on at least two wafers, existence of the continuous defects is an indication that the defect originates from the preparation and processing process of the wafer.

According to an embodiment of the present disclosure, the images of the plurality of wafers are obtained by processing the images of the plurality of wafers or reconstructing a data set of the plurality of wafers.

According to an embodiment of the present disclosure, the continuous defects occur on at least 3 wafers, preferably at least 5 wafers.

According to an embodiment of the present disclosure, the continuous defects are located on an edge of the wafer, and the continuous defects are determined by the following steps: constructing an X-Y-Z space rectangular coordinate system, and arranging a surface of the overlapped image to be perpendicular to a Z axis, determining an arc segment corresponding to each of the defects on the edge of the wafer, regarding a center point of the arc segment as a characterizing point of the defect; determining coordinates of the characterizing point in the X-Y-Z space rectangular coordinate system; on two adjacent wafers, regarding two defects corresponding to two characterization points that meet at least one of the following conditions as the continuous defects: (1) a coordinate difference of an x-axis and a coordinate difference of a y-axis of the two characterization points are smaller than a first predetermined threshold, respectively; (2) projections of the arc segments corresponding to the two characterizing points on the surface of the overlapped image are at least partially overlapped.

According to an embodiment of the present disclosure, the first predetermined threshold is determined based on a length of the arc segments corresponding to the two characterizing points.

According to an embodiment of the present disclosure, the first predetermined threshold is less than 50% of a length of a smaller one of the arc segments corresponding to the two characterization points.

According to an embodiment of the present disclosure, the continuous defects are located inside the wafer, and the method includes: constructing the X-Y-Z space rectangular coordinate system; acquiring a data set of the plurality of wafers, and reconstructing structures of the a plurality of wafers in the X-Y-Z space rectangular coordinate system based on the data set; determining a defect region on each surface of the plurality of wafers; determining a center point of the defect region as the characterizing point of the defect region; regarding two defect regions corresponding to two center points that meet at least one of the following conditions on the two adjacent wafers as the continuous defects: (1) a coordinate difference of an x-axis and a coordinate difference of a y-axis of the two characterization points are smaller than a second predetermined threshold, respectively; (2) projections of the defect regions corresponding to the two center points on the surface of the overlapped image are at least partially overlapped.

According to an embodiment of the present disclosure, the second predetermined threshold is determined by a longest segment that can be determined by the two defect regions.

According to an embodiment of the present disclosure, the second predetermined threshold is less than 50% of the longest segment.

According to an embodiment of the present disclosure, the defect region is formed by a plurality of defect points.

In another aspect of the present disclosure, the present disclosure provides a system for automatically detecting and controlling defects on a wafer. According to an embodiment of the present disclosure, the system includes: a patterning unit, configured to construct the defect distribution map based on the defect information on at least one wafer, where, the defect information includes the number of defects, types of the defect, and locations of the defects; a partitioning unit, connected to the patterning unit and configured to divide at least one predetermined region in a defect distribution map; a statistical unit, connected to the patterning unit and the partitioning unit and configured to count the number of predetermined defects in each of the at least one predetermined region; a comparison unit, connected to the statistical unit, and configured to compare the number of predetermined defects in the each of the at least one predetermined region with the set threshold, and determine the detection results based on the comparison results. The system can automatically detect the defects on the wafer, and perform partition statistics and control on the defects on at least one wafer, so that the quality of the output chips can be well guaranteed and a yield of the wafer can be improved.

According to the embodiment of the present disclosure, the forgoing system can effectively execute the forgoing method.

### Brief Description of the Drawings

FIG. 1 shows a schematic diagram of a 2D defect distribution map according to an embodiment of the present disclosure.
FIG. 2 shows a schematic diagram of a partition of a 2D defect distribution map according to an embodiment of the present disclosure.
FIG. 3 shows a schematic diagram of a partition of a 2D defect distribution map according to another embodiment of the present disclosure.
FIG. 4 shows a schematic diagram of a 3D defect distribution map according to an embodiment of the present disclosure.
FIG. 5 shows a schematic structural diagram of a system for detecting and controlling defects on a wafer according to an embodiment of the present disclosure.
FIG. 6 shows a schematic structural diagram of a system for detecting and controlling defects on a wafer according to an embodiment of the present disclosure.
FIG. 7 shows a schematic structural diagram of a system for detecting and controlling defects on a wafer according to an embodiment of the present disclosure.
FIG. 8 shows a schematic flowchart of a method for obtaining overlapped images of a plurality of wafers in a method for detecting and controlling defects on a wafer according to an embodiment of the present disclosure.
FIG. 9 shows a method for detecting and controlling defects on a wafer to obtain overlapped images of a plurality of wafers according to an embodiment of the present disclosure.
FIG. 10 shows a method for detecting and controlling defects on a wafer to obtain overlapped images of a plurality of wafers according to another embodiment of the present disclosure.
FIG. 11 shows a method for detecting and controlling defects on a wafer to obtain overlapped images of a plurality of wafers according to another embodiment of the present disclosure.
FIG. 12 shows a method for detecting and controlling defects on a wafer to obtain overlapped images of a plurality of wafers according to another embodiment of the present disclosure.
FIG. 13 shows a method for detecting and controlling defects on a wafer to obtain overlapped images of a plurality of wafers according to another embodiment of the present disclosure.

### Detailed Description of the Embodiments

Embodiments of the present disclosure are described in detail below. The embodiments described below are exemplary, and are only used to explain the present disclosure, and should not be construed as limiting the present disclosure. If specific techniques or conditions are not indicated in the embodiments, procedures shall be carried out in accordance with techniques or conditions described in literatures in the art or in accordance with a product specification. Reagents or instruments used without a manufacturer's indication are all conventional products that can be purchased commercially.

Some embodiments of the present disclosure are completed based on the following findings and knowledge :
At present, although the wafer is detected, a problem that the quality of the wafer is still not well guaranteed, and a problem in the processing process of the wafer cannot be effectively reflected, the inventor conducted an in-depth analysis and found that one of the main reasons lies in a fact that the current detection of the wafer is usually controlled based on the types and the number of defects. For example, 10 particle defects are controlled. These 10 particle defects may be scattered on a surface of an entire wafer, or may be concentrated in a certain region, or may be continuous defects (front and back slices), etc. If the defects are scattered, the defects may have less impact on the quality of the produced chips, and if the defects are concentrated in one region, the defects may seriously affect the quality of the produced chips in the regions where the defects are concentrated, that is, the current detection method does not take into account an influence of defect distribution on the quality of the produced chips. In addition, the detection apparatus is single-wafer detection at present, and it is difficult to monitor causes of defects from a single wafer. In particular, for those wafers with edge defects that still meet customer specifications, it is more difficult to detect continuous problems that may be caused by improper processing. If a method can be used to quickly find the problems in the manufacturing process, a chance of such defects recurring may be fundamentally reduced. Based on the forgoing findings, after research, the inventor proposed a method for detecting and controlling the defects that considers the types of defects, the number of defects and the distribution of the defects at the same time. Specifically, the method can be used to output the detection results of a single wafer (TFF, Klarf, CSV, image and other formats), and to automatically determine the number of defects, the types of defects, the location distribution of the defects and other conditions to ensure the quality of the produced chips or effectively reflect the problems in the processing process of the wafer.

In view of this, in one aspect of the present disclosure, an embodiment of the present disclosure provides a method for automatically detecting and controlling defects on a wafer. According to an embodiment of the present disclosure, the method includes: providing at least one stacked wafer; constructing a defect distribution map based on a defect information on each of the wafers, where, the defect information includes the number of defects, types of the defects, and locations of the defects; partitioning at least one predetermined region in the defect distribution map; determining the number of predetermined defects in each of the predetermined regions based on the locations of the defects; comparing the number of the predetermined defects in each of the predetermined regions with a set threshold, and determining detection results based on comparison results. With this method, while controlling the number and the types of the defects on the wafer, the distribution of the defects can also be controlled, thereby avoiding problems caused by the concentration of defect distribution, and better ensuring the quality of the produced wafer. Meanwhile, this method can also effectively reflect the problems existing in the processing process of the wafer by the defect distribution, thereby having a guiding significance for the manufacturing process of the wafer.

According to the embodiment of the present disclosure, a specific material of the wafer can be silicon wafer, sapphire, silicon carbide, or the like. And the wafer can be of any size,which is no limited , including but not limited to a wafer with a diameter of 100mm, 150mm, 200mm, 300mm, 400mm, 450mm, 660mm, or the like. Whereas a thickness of the wafer can be tens of microns or hundreds of microns, such as 18 microns, 20 microns, 52 microns, 67 microns, 600 microns , 725 microns, 755 microns, 770 microns, or the like, which can be flexibly selected according to actual needs, and is not repeated here.

In some embodiments, the method can detect and control defects on one wafer, and only one wafer needs to be provided at this time. In other embodiments, the method can also detect a plurality of wafers simultaneously. The plurality of wafers are stacked and arranged at this time. Specifically, circle centers of the plurality of wafers are on a straight line, and orientations of the plurality of wafers is the same, that is, when the wafer is produced, a positioning mark (such as a positioning point, a positioning groove, or the like) can be arranged at a particular location of the wafer, and alignment marks on the plurality of wafers that are stacked are aligned in a stacking direction. In this way, the locations of the defects on a plurality of wafers can be directly located in one coordinate system, which is convenient for analysis and statistics.

According to the embodiment of the present disclosure, the method can detect and control different types of defects on the wafer, such as cop (crystal original particle), pits (etch pits), particles, scratches, slips, bright field defects, a pin hole (an air pocket), or the like. Specifically, selection can be performed to detect and control one certain type of defects, several certain types of defects, or all types of defects as required .

According to some embodiments of the present disclosure, according to different needs, the method can detect and control defects in a 2D plane, and can also detect and control defects in a 3D space.

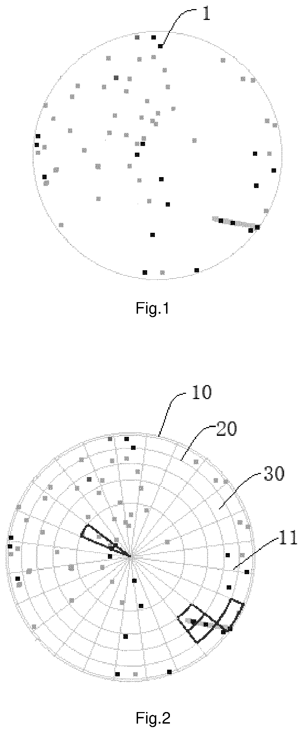

In one embodiment, a 2D defect distribution map is constructed based on a defect information on a first surface of one wafer. The first surface of the wafer refers to a circular surface of the wafer. Correspondingly, the forgoing 2D defect distribution map is a 2D circular plane corresponding to the first surface, and the 2D plane is marked with all defects on the surface and locations of the defects. In one specific embodiment, the circular 2D defect distribution map can be referred to FIG. 1. points in a circular region are defects 1, and points with different shades of colors are different types of defects.

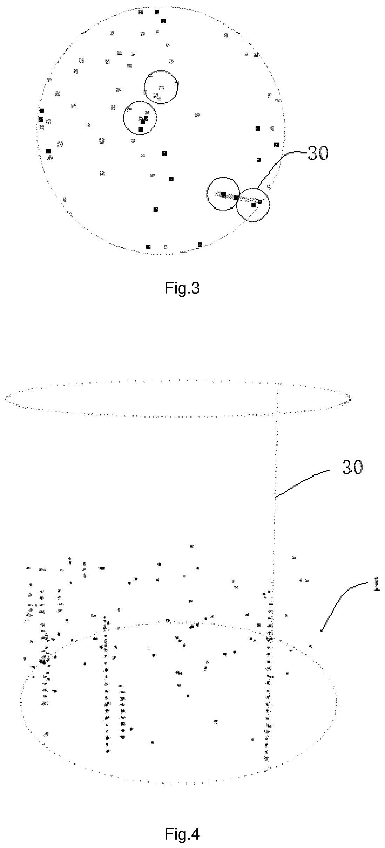

According to an embodiment of the present disclosure, the 2D defect distribution map can be partitioned by different division methods, and the division method should be able to better reflect the distribution of the defects on the 2D circular plane as much as possible. In some specific embodiments, referring to FIG. 2, an outer circumference of the first surface forms a first circle 10. Intersection of a plurality of second circles 20 which are concentric with the first circle 10 and a plurality of diameters 11 passing through a center of the first circle defines a plurality of predetermined regions 30. In other specific embodiments, referring to FIG. 3 (only four predetermined regions are shown in FIG. 3, and not all the predetermined regions are shown), each predetermined region 30 is a circular region delineated according to a predetermined radius with one of the defects as a circle center, and each of the defects corresponds to one of the predetermined regions. With the forgoing partitioning method, a concentrated distribution of the defects can be better detected and controlled, and the number of the output chips can be better guaranteed.

It should be noted that each defect may occupy a certain area instead of a point. Some embodiments of the present disclosure take one defect as a circle center . That is, the present disclosure can take any point in the defect as the circle center. In some specific embodiments, a geometric center of a map formed by the outer circumference of the defect is taken as the circle center.

It can be understood that the plurality of second circles have different radii, which can be gradually contracted from the first circle. a difference between the radii of two adjacent second circles is not particularly limited, and can be flexibly selected based on actual partitioning needs. The difference between the radii of any two adjacent second circles can be the same or different. The plurality of diameters are diameters in different directions. A certain included angle is provided between two adjacent diameters. The size of the included angle can also be flexibly selected according to the needs of the partition. The included angle between any two adjacent diameters can be the same or different.

According to an embodiment of the present disclosure, in order to better detect and control the distribution of the defects, the smaller an area of each of the predetermined regions, and the plurality of predetermined regions should be divided as evenly as possible on the entire 2D defect distribution map. However, the smaller the area of the predetermined region, the more complex the statistics. Taking different factors into consideration, the area of each of the predetermined regions can be 0.5% to 5% of a total area of the 2D defect distribution map (specifically, such as 0.5%, 1%, 1.5%, 2%, 2.5%, 3%, 3.5%, 4%, 4.5%, 5%, or the like). The area of each of the predetermined regions may be the same or different, and a specific area may be selected according to actual needs.

According to the embodiment of the present disclosure, the "predetermined defect" mentioned herein refers to a defect that satisfies certain conditions, and the specific conditions to be met can be selected according to actual needs, for example, including but not limited to one certain type of defect, sum of the plurality of certain types of defects, or the like. In some specific embodiments, when the defects on the 2D plane are detected and controlled, the number of the predetermined defects is a sum of the number of all the defects in the predetermined region. That is, after the plurality of predetermined regions are partitioned in the 2D defect distribution map, the number of all types of defects in each of the predetermined regions is counted, and then the counted number of all types of defects is compared with the set threshold.

Specifically, for the 2D defect distribution map, based on the comparison results, the step of determining the detection results includes: determining as a qualified region the predetermined region where the number of the predetermined defects is less than the set threshold, and determining as an unqualified region the predetermined region where the number of the predetermined defects is greater than or equal to the set threshold .

According to the embodiment of the present disclosure, the threshold set herein can be set artificially according to different usage requirements. For a product with higher quality requirements, the threshold can be set relatively small, while for a product with relatively lower quality requirements, the threshold can be set relatively large and can be adjusted flexibly and specifically according to actual needs.

In a specific embodiment, the method for detecting and controlling the defects on the wafer can include the following steps: providing one wafer with a diameter of 300 mm; constructing the 2D defect distribution map based on the number and locations of the defects on the wafer (referring to FIG. 1); partitioning the predetermined region with the intersection of the plurality of second circles 20 which are concentric with the first circle formed by the outer circumference of the wafer and a plurality of diameters 11 passing through a center of the first circle (referring to FIG. 2), where, the radii of the plurality of second circles are 65mm, 93mm, 113mm, 131mm and 148mm, respectively, and an included angle between two adjacent ones is 15 degrees; then counting the number of all types of defects in each of the predetermined regions; arranging the threshold as 4; comparing the number of all types of defects in each of the predetermined regions with the set threshold of 4; determining as the qualified region the predetermined region where the number of all types of defects is less than the set threshold of 4, and determining as the unqualified region the predetermined region where the number of all types of defects is greater than or equal to 4 (referring to a black frame region in FIG. 2), where, points with different shades of colors are different types of defects.

In another specific embodiment, the method for detecting and controlling the defects on the wafer can include the following steps: providing one wafer with a diameter of 300mm; constructing the 2D defect distribution based on the number and locations of defects on the wafer (referring to FIG. 1); delineating a circular predetermined region with each defect in the obtained 2D defect distribution map as the circle center according to a predetermined radius of 20mm (referring to FIG. 3), where, each defect corresponds to one of the predetermined regions; then counting the number of all types of defects in each of the predetermined regions; seting the threshold to 6; comparing the number of all types of defects in each of the predetermined regions with the set threshold of 6; determining as the qualified region the predetermined region where the number of all types of defects is less than the set threshold of 6, and determining as the unqualified region the predetermined region where the number of all types of defects is greater than or equal to 6 (referring to a black frame region in FIG. 3), where, points with different shades of colors are different types of defects.

In another embodiment, a 3D defect distribution map is constructed based on a 3D space occupied by the plurality of stacked wafers and defect information on the plurality of wafers. Specifically, the 3D defect distribution map corresponds to one cylindrical 3D space, and a specific size of the 3D defect distribution map is the same as a volume occupied by the plurality of stacked wafers, where, all the defects on the plurality of wafers and locations of the defects are marked. In one specific embodiment, the cylindrical 3D defect distribution map can be referred to FIG. 4, Points in the cylindrical space are defects 1, and points with different shades of colors are different types of defects.

According to the embodiment of the present disclosure, a general principle of partitioning of detecting and controlling defects in the 3D space is the same as the principle of detecting and controlling defects on the 2D plane ,whereas the each predetermined area is a 3D space. In some specific embodiments, the 3D space occupied by the plurality of wafers can form one predetermined region. In another specific embodiments, referring to FIG. 4 (only one predetermined region is shown in FIG. 4, and not all the predetermined regions are shown), each of the predetermined regions is a cylindrical region delineated by a predetermined bottom radius with a strainght line passing through one of the defectsand parallel to a stacking direction of the plurality of wafers as a central axis. Therefby,each of the defects corresponds to one of the predetermined regions. With the forgoing partitioning method, a concentrated distribution of the defects can be better detected and controlled, and the number of the output chips can be better guaranteed.

It should be noted that as mentioned above, the defects occupy a certain area. In the present disclosure, a straight line that passes through one of the defects and is parallel to the stacking direction of the plurality of wafers is taken as the central axis, which may pass through the any point of the defect, or pass through a geometric center of the map formed by the outer circumference of the defect specifically.

According to the embodiment of the present disclosure, the predetermined bottom radius of each of the predetermined regions can be flexibly adjusted according to actual needs, as long as the defect distribution can be better feed back the predetermined bottom radii of the plurality of predetermined regions can be the same or different . In some specific embodiments, in order to better feed back the defect distribution, a volume of each of the predetermined regions is 0.5% to 5% of a total volume of the 3D space occupied by the a plurality of wafers (such as 0.5%, 1%, 1.5%, 2%, 2.5%, 3%, 3.5%, 4%, 4.5%, 5%, or the like). As a result, the defects on the plurality of wafers can be effectively controlled. Partitioning is reasonable, and a statistical workload is not too large.

In some specific embodiments, while the defects in the 3D space are detected and controlled, the number of the predetermined defects (or called as continuous defects) is the number of defects with the same defect location on different wafers.In other words, after a plurality of predetermined regions are partitioned in the 3D defect distribution map, the defects on each wafer in the region are counted. Comparing if the locations of the defects on different wafers are the same, the number of the defects which have the same locations and are located at the different wafers are recorded (where, the defects of the same location are aligned in the stacking direction of the plurality of wafers, or orthographic projections of the defects of the same location on a bottom surface of a cylindrical space occupied by the plurality of wafers are at least partially overlapped). Therefore, in addition to detecting and controlling the defects on the wafer, the problems that may exist on a wafer production line can also be feed back. That is, if the plurality of wafers have defects at the same location,there may be a problem with the processing process corresponding to the location on the wafer.

According to the embodiment of the present disclosure, the defects,which the orthographic projection on the bottom surface of the cylindrical space occupied by the plurality of stacked waferson the different wafers are at least partially overlapped, can be regarded as the defects with the same defect location on different wafers.

According to one embodiment of the present disclosure, the predetermined defect is located on an edge of the wafer, and defects with the same location on the different wafers are determined by the following steps:
constructing an X-Y-Z space rectangular coordinate system, arranging the bottom surface of the cylindrical space occupied by the plurality of stacked wafers to be perpendicular to a z-axis, determining an arc segment corresponding to each of the defects on the edge of the wafer, and regarding a center point of the arc segment as a characterizing point of the defect; and determining coordinates of the characterizing point in the X-Y-Z space rectangular coordinate system. Two defects corresponding to two characterizing points that meet at least one of the following conditions on two adjacent wafers are regarded as the defects with the same defect location on the different wafers:
(1) Differences of coordinates of an x-axis and a y-axis of the two characterizing points are smaller than a first predetermined threshold respectively;
(2) Projections of the arc segments corresponding to the two characterizing points on the bottom surface of the cylindrical space occupied by the plurality of stacked wafers are at least partially overlapped.

Therefore, according to one embodiment of the present disclosure, while the difference of the coordinates of the x-axis and the y-axis of the two characterizing points is smaller than the first predetermined threshold, the two defects corresponding to the two characterizing points can be regarded as the defects with the same defect location on the different wafers.

According to another embodiment of the present disclosure, while the projections of the arc segments corresponding to the two characterizing points on the bottom surface of the cylindrical space occupied by the plurality of stacked wafers are at least partially overlapped, the two defects corresponding to the two characterizing points can be regarded as defects with the same defect location on the different wafers. Specifically, a length of an overlapping portion is at least 50% of a length of the shorter arc segment.

According to another embodiment of the present disclosure, while the coordinate difference of the x-axis and the coordinate difference of the y-axis of the two characterizing points are smaller than the first predetermined threshold respectively, and the projections of the arc segments corresponding to the two characterizing points on the bottom surface of the cylindrical space occupied by the plurality of stacked wafers are also at least partially overlapped, the two defects corresponding to the two characterizing points can be regarded as defects with the same defect location on the different wafers.

According to a specific embodiment of the present disclosure, the projections of the arc segments corresponding to the two characterizing points on the bottom surface of the cylindrical space occupied by the a plurality of stacked wafers are also at least partially overlapped, that is, part of the x coordinate and part of the y coordinate of the two arc segments are the same.

According to a specific embodiment of the present disclosure, the first predetermined threshold is determined based on a length of the arc segments corresponding to the two characterizing points. Specifically, the first predetermined threshold is less than 50% of the length of the smaller one of the arc segments corresponding to the two characterization points. Therefore, specifically, when the difference of the coordinates of the x-axis and the difference of the coordinates of the y-axis of the two characterizing points are smaller, it means that the more the two defect arc segments are overlapped, the closer the locations of the two defects, and the greater a relevance. Furthermore, analyzing the predetermined defects is more significant for optimizing and adjusting the preparation process of the wafer.

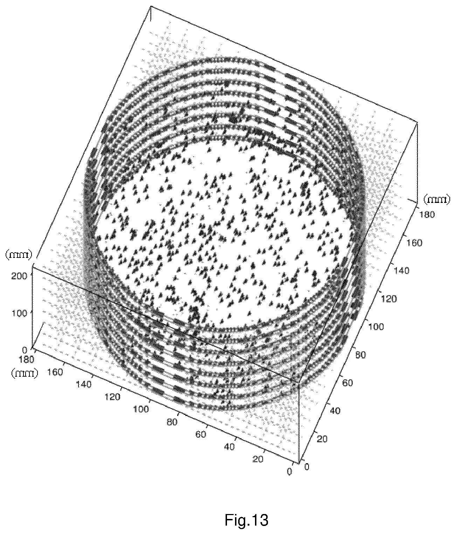

According to an embodiment of the present disclosure, the predetermined defect is located inside the wafer, and a method for determining the defects with the same defect location on different wafers includes:
constructing an XYZ space rectangular coordinate system; arranging the bottom surface of the cylindrical space occupied by the plurality of stacked wafers to be perpendicular to the z-axis, determining the defect region on each surface of the plurality of wafers; determining a center point of the defect region as the characterizing point of the defect region (such as a stack of defect images on a surface of the wafer as shown in FIG. 13);

For the plurality of wafers, two defect regions corresponding to two center points that meet at least one of the following conditions are regarded as defects with the same defect location on the different wafers:
(1) The difference of the coordinate of the x-axis and the difference of the coordinate of the y-axis of the two central points are smaller than a second predetermined threshold, respectively;
(2) The projections of the defect regions corresponding to the two center points on the bottom surface of the cylindrical space occupied by the plurality of stacked wafers are at least partially overlapped.

Therefore, when the defects with the same defect location on the different wafers are located inside the wafer, in an embodiment of the present disclosure, a plurality of densely distributed defects on one wafer are regarded as one defect region. If the defect region appears in the same location of the plurality of the wafers, the plurality of defect regions are defects with the same defect location on the different wafers. While two adjacent defect regions are not completely the same, it can be determined whether the defects are the same defects with the same defect location on the different wafers based on the differences of the coordinates of the center point of the defect region. For example,while the difference of the coordinates of the x-axis and the y-axis of the two center points are smaller than the second predetermined threshold respectively, the defects can be regarded as the defects with the same defect location on the different wafers. It can also be determined whether the defects are the same defects with the same defect location on the different wafers according to whether the two defect regions are overlapped. For example, if the projections of two defect regions on the two wafers on the bottom surface of the cylindrical space occupied by the plurality of stacked wafers are at least partially overlapped, it can be considered that the defects are the same defects with the same defect location on the different wafers. Therefore, it is possible to analyze the defects with the same defect location on the different wafers, which is used to guide the optimization of the wafer preparation process, so as to improvethe quality of the wafer originally.

According to one embodiment of the present disclosure, the second predetermined threshold is determined by the longest segment that can be determined by the two defect regions. That is, each of the defect regions may be an irregular region, and a distance between the two furthest points on the edge of the irregular region is set as the longest segment. The second predetermined threshold is less than 50% of the longest segment. When the difference of the coordinate of the x-axis and the difference of the coordinate of the y-axis of the two central points are smaller than a second predetermined threshold, respectively. Specifically, the smaller the differences of the coordinates of the x-axis and the y-axis of the two center points, the larger the overlapped region of the two defect regions, the closer the positions of the two defect regions, and the greater the relevance. Furthermore, analyzing the defects with the same defect location on the different wafers is more significant for optimizing and adjusting the preparation process of the wafers.

According to a specific embodiment of the present disclosure, the defect region on the forgoing wafer is formed by the plurality of defects. At least 1% of the defects in the two regions of the defect with the same defect location on the different wafers determined to be on a z-axis direction are completely identical, that is, at least 1% of the defects in the z-axis has a similar x coordinate and a similar y coordinate .

According to a specific embodiment of the present disclosure, in the forgoing method for determining the defects with the same defect location on the different wafers, the projections of the defect regions corresponding to the two center points on the bottom surface of the cylindrical space occupied by the plurality of stacked wafers are at least partially overlapped. Specifically, an overlapping area is at least 50% of an area of the smaller defect region, which ensure the relevance of the two defect regions, so as to analyze the reasons for the defects accurately , guide a method of preparing the wafer and improve the quality of the wafer.

Specifically, for the 3D defect distribution map, in some embodiments, based on the comparison results, determining the detection results includes: determining as the qualified region the predetermined region where the number of the predetermined defects is less than the set threshold, and determining as the unqualified region the predetermined region where the number of the predetermined defects is greater than or equal to the set threshold . In some embodiments, the plurality of stacked wafers are derived from the same ingot. Based on the comparison results, the step of determining the detection results includes: if the number of predetermined defects is greater than or equal to the set threshold, determining the predetermined defects originates from a preparation and processing process of the wafer.

In one specific embodiment, the method for detecting and controlling the defects on the wafer includes the following steps: providing a plurality of 300mm stacked wafers; constructing the 3D defect distribution map (referring to FIG. 4) based on the 3D space occupied by the plurality of stacked wafers and the number of defects and defect locations on the plurality of wafers; then partitioning predetermined regions in the 3D defect distribution map, where each of the predetermined regions defined by a predetermined bottom radius of 2 mm is a cylindrical region, which is formed by taking a straight line passing through one of the defects and parallel to a stacking direction of the plurality of the wafers as a central axis, where, each of the defects corresponds to one of the predetermined regions; counting the number of defects with the same defect location on the different wafers in each predetermined region; compared the number of defects with the set threshold 2; determining as a qualified region the predetermined region where the number of defects with the same defect location on the different wafers is less than the set threshold; and determining as an unqualified region the predetermined region where the number of defects with the same defect location on the different wafers is greater than or equal to the set threshold 2 (referring to the predetermined region 30 shown in FIG. 4).

In another specific embodiment, the method for detecting and controlling the defects on the wafer includes the following steps: providing the plurality of stacked wafers, the diameter of which is 300 mm; constructing the 3D defect distribution map (referring to FIG. 4) based on the 3D space occupied by the plurality of stacked wafers and the number of defects and the defect locations on the plurality of wafers; taking a space occupied by the plurality of wafers as a predetermined region; then counting the number of defects with the same defect location on the different wafers in the predetermined region; comparing the number of defects with the set threshold 2; and if the number of defects with the same defect location on the different wafers is greater than or equal to 2, determining that the predetermined defect originates from the preparation and processing process of the wafer.

According to the embodiment of the present disclosure, the number of defects, the types of defects, and the defect locations on each of the wafers are detected by a conventional method. The defects such as crystal original particles, pits, particles, scratches, bright field defects, and slips can be detected by laser scanning (such as using KLA SP series and Hitachi LS series of a laser scanning apparatus), SIRD detection, infrared scanning, or the like.,besides,air holes are detected by infrared scanning, X-ray, or the like. The detection data of forgoing defects is output from the apparatus. The detection data may be images of the wafers or all defect information documents. In this method, the defect distribution map can be constructed directly based on the images (the defect image, and a detection image) of the forgoing wafers or all defect information documents.

In another specific embodiment, the method for detecting and controlling the defects on the wafer includes the following steps: taking the space occupied by the plurality of wafers as one predetermined region; acquiring images of the plurality of wafers, where, the plurality of wafers are from a same ingot, and positioning points are formed on edges of the plurality of wafers, respectively; stereoscopically overlapping and processing the images of the plurality of wafers based on the positioning points, thereby acquiring overlapped images of the plurality of wafers; searching for defects on the overlapped images to determine whether there are continuous defects, wherein,the continuous defects occur at the same location on at least two adjacent wafers, presence of the continuous defects is an indication that the defect originates from the preparation and processing process of the wafer. At present, most of the existing methods for inspecting the wafer are to inspect a single wafer. The inventor found that singlewafer detection makes wafer defects more independent, which is inconvenient for statistical analysis of the defects, and may even isolate imperceptibly related defects. Therefore, the inventor believed that the single wafer detection cannot find commonality and relevance of the defects among the plurality of wafers, which increases the difficulty of analyzing a cause of the defect. For this reason, it is proposed to integrate the images of the plurality of wafers from the same ingot into the overlapped images, search for the defects on the overlapped image to determine whether there are continuous defects,that is, the continuous defects occur at the same location on at least two adjacent wafers. The existence of the continuous defects is an indication that the defect originates from the preparation process of the wafer. Therefore, the method of the forgoing embodiment of the present disclosure can more conveniently and clearly discover the commonality and relevance between the defects on the adjacent wafers, thereby facilitating the statistical analysis of the defects. The defects generated in the manufacturing process of the wafer may be caused by an improper processing apparatus or the improper manufacturing process. Therefore, this method can be used to monitor the defect distribution on the wafers of each production batch. If the defects are continuously generated, the defects can be found and corrected in real time as soon as possible, thereby increasing productivity and reducing losses.

Specifically, the images of the plurality of wafers which are from the same ingot, are obtained. Positioning points are formed on edges of the plurality of wafers, respectively. The images of the plurality of wafers are stereoscopically overlapped and aligned based on the positioning points, thereby acquiring the overlapped images of the plurality of wafers. The 3D overlapping processing method can be a parallel alignment processing method, an oblique alignment processing method, a rotation alignment processing method, and the like. The 3D overlapping processing in the following embodiments is described by the parallel alignment processing method, and the protection of this technical solution is not limited by the specific alignment method.

According to an embodiment of the present disclosure, the images of the plurality of wafers are obtained by performing image processing on the plurality of wafers or reconstructing data sets of the plurality of wafers. That is, the stereoscopic image of the single wafe is obtained by scanning the wafer or by reconstruction of the data sets of the wafer.

Specifically, the positioning points are formed on an edge of the image of each wafer, respectively. Based on the positioning points on each image, the images of the plurality of wafers are aligned in an original order in parallel to obtain the overlapped images of the plurality of wafers.

According to a specific embodiment of the present disclosure, the overlapped images of the plurality of wafers can be produced with an OPENGL platform or a DirectX platform.

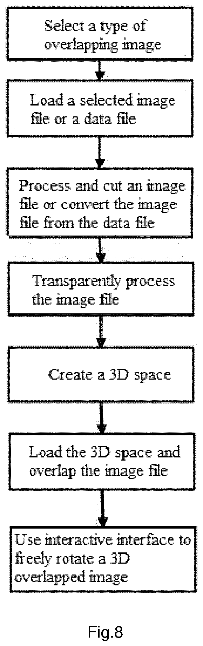

According to one specific embodiment of the present disclosure, the step of producing the overlapped image is performed in the following steps: selecting a type of overlapped image; loading the overlapped image into a selected image file or a data file; processing and cutting an image file or converting the image file from the data file; processing the image file transparently; creating the 3D space; loading the 3D space; and overlapping the image files to obtain the overlapped image (referring to FIG. 8).

According to a specific embodiment of the present disclosure, the image files in the forgoing steps include processing parameters and surface parameters. The processing parameters include: thickness, bow, warp, flatness, nano-topography, or the like. The surface parameters include: scratches, cracks, line marks, air holes, chip, or the like.

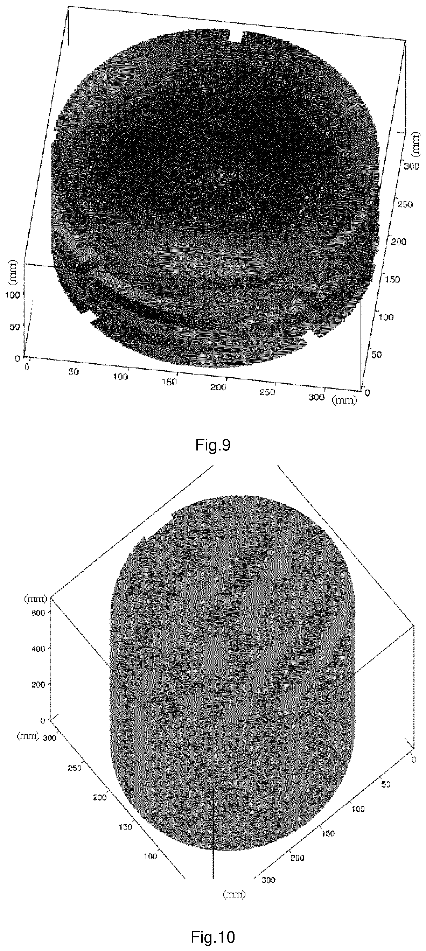

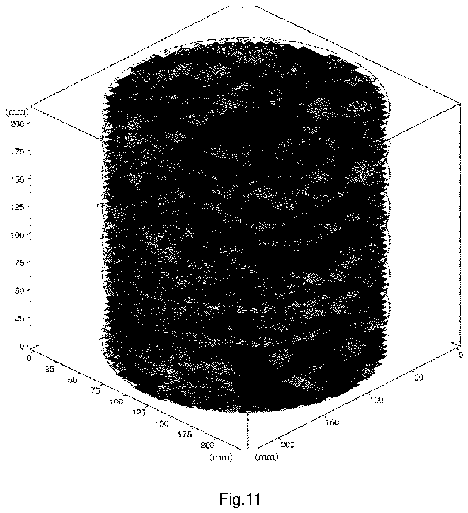

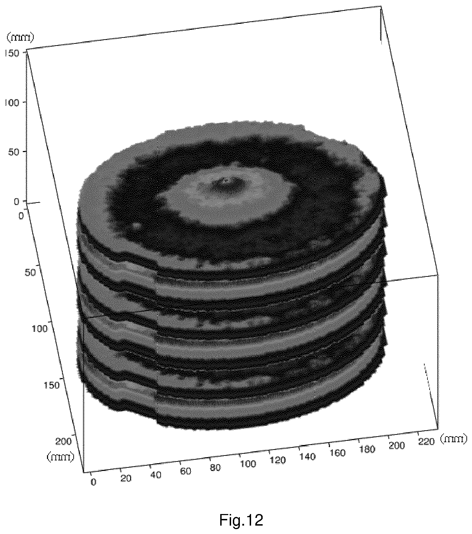

According to a specific embodiment of the present disclosure, the overlapped image prepared by the forgoing method is shown in FIGS. 9-12. Specifically, FIG. 9 is overlapping of wafer thickness images. FIG. 10 is overlapping of nano-topological images of the wafer surface. FIG. 11 is overlapping of wafer SPV images. FIG. 12 is overlapping of 3D wafer thickness images.

Specifically, the defects on the overlapped image are searched for to determine whether there are the continuous defects, wherein, the continuous defects occur at the same location on at least two adjacent wafers, the existence of the continuous defects is an indication that the defects are derived form the preparation process of the wafer.

Thus, by observing the overlapped images by overlapping of the plurality of wafers, the relevance of the defects on the wafer can be found. For example, the same defects are defined as the continuous defects ,which occurs at the same location on a plurality of consecutive wafers and can be correlated. By analyzing the cause of the continuous defect which come from the step in the wafer preparation process, it provides guidance on the optimization or adjustment of the preparation process.

According to an embodiment of the present disclosure, the forgoing continuous defects need to appear on at least 3 wafers. The defects that only appear on one or two wafers are accidental, and may also appear randomly, so the defects have no analytical value and cannot be confirmed as the continuous defects.

According to an embodiment of the present disclosure, the forgoing continuous defects occur on at least 5 wafers. Therefore, it can be considered that the defects are generated during a process of preparing the wafer. Analyzing the cause of the defects is more valuable for optimizing and adjusting the preparation process.

It should be noted that the method for determining the continuous defects is the same as the method for determining the defects with the same defect location on the different wafers described above, which is not repeated here.

The forgoing method of the present disclosure can automatically monitor the defect distribution of the surface of the wafer, effectively intercept wafers with specific defects on the surface of the wafer, and can achieve an effect of detecting and controlling the number of surface defects and the defect distribution of a silicon wafer, while the prior art is not achieve thereby avoiding an abnormality of specific defect wafers on a client -side ,affecting a yield of the client-side, and effectively improving customer satisfaction.

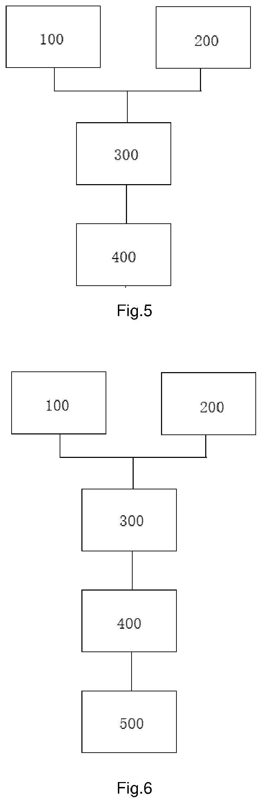

In another aspect of the present disclosure, some embodiments of the present disclosure provide a system for automatically detecting and controlling defects on a wafer. According to an embodiment of the present disclosure, referring to FIG. 5, the system includes: a patterning unit 100, configured to construct a defect distribution map based on defect information on at least one wafer; a partitioning unit 200, connected to the patterning unit and configured to divide at least one predetermined region in the defect distribution map; a statistical unit 300, connected to the patterning unit 100 and the partitioning unit 200 and configured to count the number of predetermined defects in each of the at least one predetermined region; a comparison unit 400, connected to the statistical unit 300, and configured to compare the number of predetermined defects in each of the at least one predetermined region with a set threshold, and determine detection results based on comparison results. The system can automatically detecting the defects on the wafer, and perform partitioning statistics and control to the defects on at least one wafer, so that the quality of the produced wafer can be well guaranteed and the yield can be improved.

According to an embodiment of the present disclosure, referring to FIG. 6, the system further include a result output unit 500 connected to the comparison unit 400 and configured to output the detection results. As a result, it is convenient for technicians to read the detection results.

According to the embodiment of the present disclosure, the forgoing system effectively executes the forgoing method, wherein, a specific working process of each unit can be performed with reference to the forgoing method, which is not repeated here.

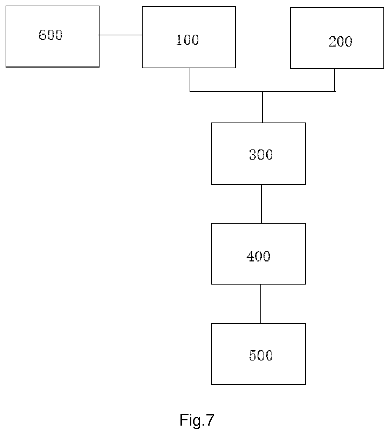

In some embodiments, a detection data file obtained by the forgoing detection can be directly input into a composition unit to construct the defect distribution map, and then proceed to the subsequent steps. In another embodiments, referring to FIG. 7, the system further include a detection unit 600 for detecting the defects on the wafer. The detection unit 600 connected to the patterning unit, can automatically detect the defects on the wafer, generates the detection data, outputs the detection data to the composition unit, and then proceeds to the subsequent steps in sequence. In the description of this specification, the description with reference to the terms "one embodiment", "some embodiments", "a specific example", or "some examples" mean that the specific feature, structure, material, or characteristic described in combination with the embodiment or example is included in at least one embodiment or example of the present disclosure. In this specification, the schematic representation of the forgoing terms does not necessarily refer to the same embodiment or example. Moreover, the described specific features, structures, materials or characteristics can be combined in any one or more embodiments or examples in a suitable manner. In addition, the person skilled in the art can combine the different embodiments or examples and the features of the different embodiments or examples described in this specification without contradicting each other.

Although the embodiments of the present disclosure have been shown and described above, it can be understood that the forgoing embodiments are exemplary and should not be construed as limiting the present disclosure. The person skilled in the art can make changes, modifications, substitutions, and variations for the foregoing embodiments within the scope of the present disclosure.

## Claims

1. A method for automatically detecting and controlling defects on a wafer, comprising:
providing at least one stacked wafer;
constructing a defect distribution map based on a defect information on each of the at least one wafer, wherein the defect information comprises the number of defects, types of the defects, and locations of the defects;
partitioning at least one predetermined region in the defect distribution map;
determining a number of predetermined defects in each of the at least one predetermined region based on the locations of the defects; and
comparing the number of the predetermined defects in the each of the at least one predetermined region with a set threshold, and determining a detection result based on a comparison result.

2. The method as claimed in claim 1, wherein a 2D defect distribution map is constructed based on the defect information on a first surface of one of the at least one wafer.

3. The method as claimed in claim 2, wherein the each of the at least one predetermined region satisfies any one of following conditions:
an outer circumference of the first surface forms a first circle, and intersection of a plurality of second circles that are concentric with the first circle and a plurality of diameters passing through the first circle defines a plurality of the predetermined regions;
the each predetermined region is a circular region delineated according to a predetermined radius with one of the defects as a circle center, and each of the defects corresponds to one of the plurality of the predetermined regions.

4. The method as claimed in claim 2 or 3, wherein the number of the predetermined defects is a sum of the number of all the defects in a corresponding predetermined region;
optionally, a step of determining the detection result based on the comparison result comprises: determining as a qualified region the predetermined region where the number of the predetermined defects is less than the set threshold, and determining as an unqualified region the predetermined region where the number of the predetermined defects is greater than or equal to the set threshold.

5. The method as claimed in any one of claims 2-4, wherein an area of the each of the at least one predetermined region is 0.5%^{~}5% of a total area of the 2D defect distribution map.

6. The method as claimed in claim 1, wherein a 3D defect distribution map is constructed based on a 3D space occupied by a plurality of wafers and defect information on the plurality of wafers;
optionally, a volume of the each of the at least one predetermined region is 0.5%^{~}5% of a total volume of the 3D space occupied by the plurality of wafers.

7. The method as claimed in claim 6, wherein the each predetermined region satisfies any one of following conditions:
the predetermined region is the 3D space occupied by the plurality of the wafers;
each of the at least one predetermined region is a cylindrical region delineated by a predetermined bottom radius, with a straight line passing through one of the defects and parallel to a stacking direction of the plurality of wafers as a central axis, and each of the defects corresponds to one of the predetermined regions.

8. The method as claimed in claim 6 or 7, wherein the number of the predetermined defects is the number of defects with a same defect location on different wafers;
optionally, based on the comparison result, it is determined that the detection result comprises any one of the following:
determining as a qualified region the predetermined region where the number of the predetermined defects is less than a set threshold, and determining as an unqualified region the predetermined region where the number of the predetermined defects is greater than or equal to the set threshold.
the plurality of stacked wafers are derived from a same ingot, if the number of the predetermined defects is greater than or equal to the set threshold, determining that the predetermined defects are derived from a preparation and processing process of the wafer.

9. The method as claimed in any one of claims 1 and 6-8, wherein each predetermined region is a 3D space occupied by a plurality of wafers, and the method comprises:
acquiring images of the plurality of wafers, wherein the plurality of wafers are derived from a same ingot, and positioning points are formed on edges of the plurality of wafers;
stereoscopically overlapping and processing the images of the plurality of wafers based on the positioning points, thereby acquiring an overlapped image of the plurality of wafers;
searching for defects on the overlapped image to determine whether there are continuous defects , thar is, the continuous defects occur at a same location on at least two wafers, wherein existence of the continuous defects is an indication that the defects are derived from a preparation and processing process of the wafer.

10. The method as claimed in claim 9, wherein the images of the a plurality of wafers are obtained by performing an image processing on the a plurality of wafers or reconstructing a data set of the plurality of wafers.

11. The method as claimed in claim 9 or 10, wherein the continuous defects occur on at least 3 wafers, preferably at least 5 wafers.

12. The method as claimed in any one of claims 9-11, wherein the continuous defects are located on an edge of the wafer, and the continuous defects are determined by following steps:
constructing an X-Y-Z space rectangular coordinate system, and arranging a surface of the overlapped image to be perpendicular to a z axis,
determining an arc segment corresponding to each of the defects on the edge of the wafer, and regarding a center point of the arc segment as a characterizing point of the defect;
determining coordinates of the characterizing point in the X-Y-Z space rectangular coordinate system;
regarding two defects corresponding to two characterizing points that meet at least one of the following conditions on two adjacent wafers as the continuous defects:
(1) a coordinate difference of an x-axis and a coordinate difference of a y-axis of the two characterizing points are smaller than a first predetermined threshold, respectively;
(2) projections of the arc segments corresponding to the two characterizing points on the surface of the overlapped image are at least partially overlapped.

13. The method as claimed in claim 12, wherein the first predetermined threshold is determined based on a length of the arc segments corresponding to the two characteristic points.

14. The method as claimed in claim 12 or 13, wherein the first predetermined threshold is less than 50% of a length of the smaller one of the arc segments corresponding to the two characterization points.

15. The method as claimed in claim 9, wherein the continuous defects are located inside the wafer, and the method comprises:
constructing the X-Y-Z space rectangular coordinate system;
acquiring a data set of the plurality of wafers, and reconstructing a structure of the plurality of wafers in the X-Y-Z space rectangular coordinate system based on the data set;
determining a defect region on each of surfaces of the plurality of wafers, respectively;
determining a center point of the defect region as a characterizing point of the defect region;
regarding two defect regions corresponding to two central points that meet at least one of the following conditions on two adjacent wafers as the continuous defects:
(1) a coordinate difference of an x-axis and a coordinate difference of a y-axis of the two central points are smaller than a second predetermined threshold, respectively;
(2) projections of the defect regions corresponding to the two central points on the surface of the overlapped imageare at least partially overlapped.

16. The method as claimed in claim 15, wherein the second predetermined threshold is determined by a longest segment that is determined by the two defect regions.

17. The method as claimed in claim 15 or 16, wherein the second predetermined threshold is less than 50% of a length of a longest arc segment.

18. The method as claimed in any one of claims 15-17, wherein the defect region is formed by a plurality of defect points.

19. A system for automatically detecting and controlling defects on a wafer, comprising:
a patterning unit, configured to construct a defect distribution map based on defect information on at least one wafer, wherein the defect information comprises a number of defects, types of the defects, and locations of the defects;
a partitioning unit, connected to the patterning unit and configured to partition at least one predetermined region in the defect distribution map;
a statistical unit, connected to the patterning unit and the partitioning unit, and configured to count the number of predetermined defects in each of the at least one predetermined region;
a comparison unit, connected to the statistical unit, and configured to compare the number of the predetermined defects in the each of the at least one predetermined region with a set threshold, and determining a detection result based on a comparison result.

20. The system as claimed in claim 19, wherein the system is configured to execute the method as claimed in any one of claims 1-18.
